# FASCICULE DE BREVET EUROPEEN

(11) **EP 1 972 061 B1**
(45) Date de publication et mention de la délivrance du brevet: **09.11.2011**
(21) Numéro de dépôt: 06841959.7
(22) Date de dépôt: 15.12.2006
(51) Int. Cl.: H03M 7/40, H04N 7/30, H04N 7/50

(54) **PROCEDE D'ENCODAGE DE TYPE CABAC**
CODIERUNGSVERFAHREN DES CABAC-TYPS
CABAC-TYPE ENCODING METHOD

(30) Priorité: 22.12.2005 FR 0513140
(43) Date de publication de la demande: 24.09.2008
(73) Titulaire: ASSISTANCE TECHNIQUE ET ETUDE DE MATERIELS ELECTRONIQUES - ATEME, 91570 Bievres (FR)
(72) Inventeur: BACRI, Stéphane, F-75015 Paris (FR)
(74) Mandataire: Oudin, Stéphane
(86) Numéro de dépôt international: PCT/FR2006/002756
(87) Numéro de publication internationale: WO 2007/080285

(56) Documents cités:
- EP-A- 1 189 354
- US-A1- 2005 052 295
- US-A1- 2005 258 982
- WIEGAND T: "DRAFT TEXT OF FINAL DRAFT INTERNATIONAL STANDARD FOR ADVANCED VIDEO CODING (ITU-T REC. H.264/ISO/IEC 14496-10 AVC)" ISO/IEC JTC1/SC29/WG11 N5555, PATTAYA,, TH, 31 mars 2003 (2003-03-31), pages I-XVI,1, XP001091555

## Description

La présente invention concerne un procédé et un dispositif d'encodage, du type CABAC (Codage arithmétique binaire à contexte adaptatif), d'un flux initial d'informations numériques binaires destinées à générer un flux sortant pour former, après décodage, des images vidéo.

On sait que la syntaxe et les procédés permettant d'assurer le décodage d'un flux d'informations vidéo sont définis dans le standard de compression vidéo dit ITU H.264 ou ISO/IEC 14496 MPEG-4 Part.10. Ce standard propose, à titre informatif, des procédés permettant de produire des flux compressés d'informations.

Les dispositifs d'encodage générant des flux conformes à ce standard comportent un étage d'encodage dont la tâche est de générer un flux binaire qui est représentatif des informations à transmettre. Cet étage d'encodage peut faire appel à deux méthodes dites respectivement CAVLC (Codage de longueur variable à contexte adaptatif) et CABAC. Cette dernière méthode est plus intéressante en ce qu'elle génère un flux binaire dont le débit est plus faible que celui produit par la première, au détriment cependant d'une plus grande complexité.

On sait que la méthode CABAC comporte une étape, dite «renormalisation». Cette étape fait appel à un processus itératif qui constitue en quelque sorte le «goulot d'étranglement» de la méthode, dans la mesure où, par principe même, son temps d'exécution est relativement long.

La présente invention a pour but de proposer un procédé et un dispositif d'encodage dans lesquels on remplace le processus itératif de l'état antérieur de la technique par un processus permettant d'accéder de façon directe aux mêmes résultats, et ceci à partir des mêmes paramètres d'entrée.

La présente invention a ainsi pour objet un dispositif d'encodage de type CABAC d'un flux initial d'informations numériques binaires destinées à générer un flux sortant pour former, après décodage, des images vidéo, comprenant :
- des moyens aptes à analyser bit à bit des séquences successives de bits du flux binaire initial et à déduire, pour chaque bit, un intervalle représentant la probabilité d'occurrence associée à ce bit défini, par sa taille et sa borne inférieure,
- des moyens aptes à analyser cet intervalle et à assurer, si nécessaire, une renormalisation de celui-ci, caractérisé en ce que les moyens aptes à assurer cette renormalisation comportent :
- une table de référence contenant, pour chaque valeur possible de ladite borne inférieure et de ladite taille, des séquences de bits à insérer dans le flux sortant, et le nombre des bits inconnus, qui sont en attente d'insertion pour cette étape spécifique de renormalisation,
- des moyens aptes à déterminer l'adresse, dans cette table de référence, des dites données et ceci par concaténation des valeurs initiales de la taille dudit intervalle et de sa borne inférieure afin d'en extraire notamment une séquence de bits à insérer.

Le dispositif suivant l'invention comportera également des moyens aptes d'une part à assurer l'insertion, dans le flux sortant,
- du bit de poids fort de la séquence desdits bits à insérer,
- de l'inverse dudit bit de poids fort, et ceci un nombre de fois égal à la valeur du nombre de bits en attente avant la renormalisation,
- des autres bits de ladite séquence de bits à insérer,
- et d'autre part des moyens aptes à remettre à zéro, la valeur du nombre de bits en attente avant la renormalisation, sous réserve que ceux-ci aient été insérés, puis ajouter la valeur du nombre de bits inconnus en attente d'insertion à la valeur du nombre de bits en attente avant la renormalisation.

La table de référence sera préférentiellement stockée dans une mémoire dont la capacité utile sera de l'ordre de 508 mots.

Par ailleurs les moyens aptes à assurer la renormalisation seront contenus dans un composant de type « circuit intégré pour application spécifique » (ASIC) ou «réseau de portes programmables in-situ » (FPGA).

La présente invention permet ainsi, en raison de la diminution très importante du nombre de cycles nécessaires, soit de diminuer la fréquence de fonctionnement, ce qui permet de réduire la consommation électrique du dispositif d'encodage tout en conservant ses performances, soit d'augmenter la performance du dispositif, c'est à dire de générer des flux compressés à plus haut débit, et ceci sans changer la fréquence de fonctionnement.

La présente invention a également pour objet un procédé d'encodage de type CABAC, d'un flux initial d'informations numériques binaires destinées à générer un flux sortant pour former, après décodage, des images vidéo dans lequel :
- on analyse bit à bit des séries successives de bits du flux binaire initial et on en déduit, pour chaque bit, un intervalle représentant la probabilité d'occurrence associée à ce bit, défini par sa taille et sa borne inférieure,
- on analyse cet intervalle et on assure, si nécessaire, une renormalisation de celui-ci, caractérisé en ce qu'il comporte une étape unique et préliminaire au cours de laquelle on constitue une table de référence, ce procédé comportant les phases consistant à :
- établir, pour chacune des valeurs possibles de la borne inférieure et la taille, la série des valeurs des bits à insérer dans le flux sortant obtenues à partir d'une détermination des valeurs fournies par les diverses itérations successives fonction de la taille, compte tenu que ces valeurs pourront être déterminées et seront alors égales à 0 ou à 1, ou indéterminées,
- prendre en considération successivement chacune de ces valeurs et
- si une valeur est déterminée, mettre celle-ci dans la séquence des bits à insérer,
- si une valeur est indéterminée, prendre en considération au moins la valeur suivante jusqu'à ce que l'on arrive à une valeur déterminée ou à la fin de la série, dès lors :
   a) si la fin de la série est atteinte avant d'avoir une valeur déterminée, incrémenter la valeur des bits inconnus en attente pour cette série d'un nombre égal à celui du nombre des valeurs indéterminées rencontrées,
   b) si non, insérer un bit égal à ladite valeur suivante et faire suivre celui-ci d'autant de bits inversés que de valeurs indéterminées le précédant,
- mettre dans la table la valeur du nombre de bits inconnus en attente pour cette série.

Suivant l'invention la renormalisation comportera les étapes consistant à :
- déterminer l'adresse, dans la table de référence, des dites données par concaténation de la valeur initiale de la taille dudit intervalle et de la valeur initiale de sa borne inférieure,
- accéder aux dites valeurs et extraire les bits devant être insérés dans le flux sortant.

Une fois les bits à insérer extraits de la table, leur insertion dans le flux sortant comportera les étapes consistant :
- s'il n'y a aucun bit à insérer, à incrémenter le nombre de bits en attente avant la renormalisation d'un nombre égal au nombre des bits inconnus en attente de la table,
- s'il y a des bits à insérer, à insérer
   a)le bit de poids fort de la séquence desdits bits à insérer, suivi
   b) de l'inverse de ce bit de poids fort, et ceci un nombre de fois égal à la valeur du nombre de bits en attente avant la renormalisation, suivi
   c) des autres bits à insérer,
   d) remplacer le nombre de bits en attente avant la renormalisation par le nombre de bits inconnus en attente lu dans la table.

On décrira ci-après, à titre d'exemple non limitatif, une forme d'exécution de la présente invention, en référence au dessin annexé sur lequel :
- la figure 1 est une représentation schématique d'un encodeur conforme au standard H.264 montrant les différents modules permettant d'exécuter les étapes de mise en oeuvre de la méthode CABAC,
- la figure 2 est une représentation schématique des différentes étapes de la phase de renormalisation suivant l'état antérieur de la technique,
- la figure 3 est une représentation schématique des différentes étapes de la phase de renormalisation suivant l'invention,
- la figure 4 est une représentation de la table de référence utilisée dans le dispositif et le procédé suivant l'invention,
- les figures 5 et 6 représentent de façon schématique deux exemples de dispositifs électroniques permettant de mettre en oeuvre respectivement les étapes de lecture et d'insertion de bits suivant la présente invention,
- la figure 7 est une vue schématique d'un détail de mise en oeuvre de la figure 6, à savoir un sous module d'insertion de bits.

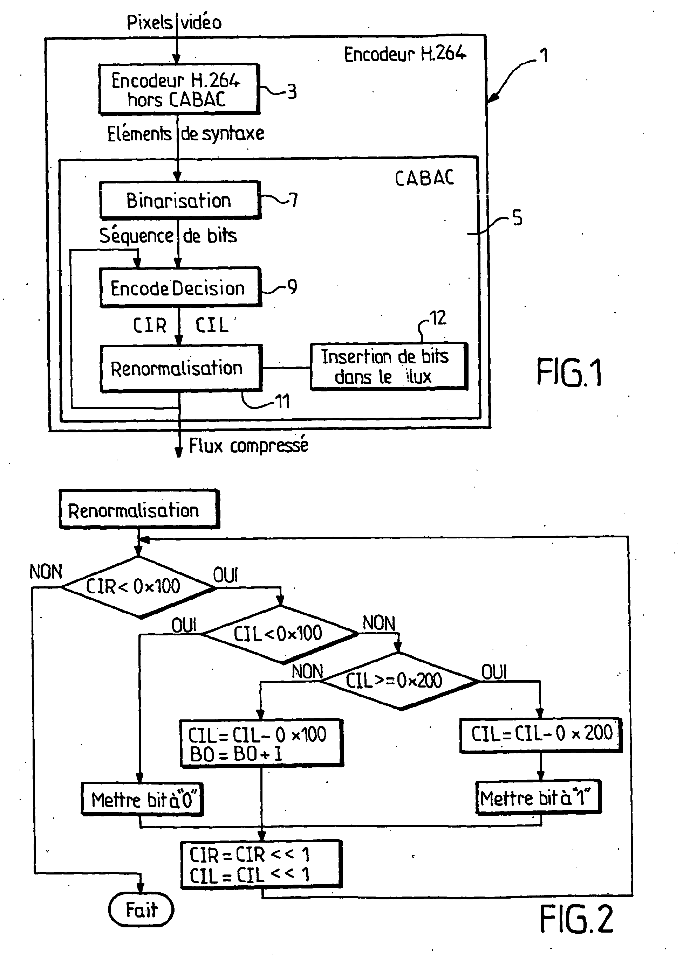

Ainsi que représenté sur la figure 1, l'encodeur 1 conforme au standard H.264 comprend des moyens encodeurs 3, qui, à réception des pixels vidéo, fournissent en sortie, des données, appelées éléments de syntaxe, qui sont envoyées vers des moyens d'encodage conformes à la méthode CABAC. Pour des raisons de simplification, ces moyens 5 seront désignés ci-après par « le CABAC ».

Le CABAC 5 possède ainsi des moyens de binarisation 7 qui transforment les éléments de syntaxe en séquences de bits, qui sont suivis de moyens 9 dénommés « EncodeDecision » dans le standard H.264 et qui analysent, bit à bit, ces séquences de bits afin d'en déduire un intervalle qui est représentatif de la probabilité d'occurrence associée au bit considéré. Cet intervalle est caractérisé par deux paramètres, à savoir, d'une part, sa taille dénommée « CodIRange » dans ladite norme et qui est désigné ci-après CIR, et d'autre part, sa borne inférieure dénommée « CodILow » dans ladite norme et qui est désigné ci-après par CIL.

Ces moyens EncodeDecision 9 sont en relation avec des moyens 11 qui mettent en oeuvre la fonction de renormalisation précédemment mentionnée. Cette fonction assure l'analyse de chacun desdits intervalles associés à chacun des bits de ladite séquence de bits et décide si celui-ci doit être ou non remis à l'échelle, autrement dit renormalisé. Lorsqu'il s'avère que la renormalisation n'est pas nécessaire, cette étape est court-circuitée.

Les moyens de renormalisation 11 sont suivis de moyens d'insertion 12 dont le rôle est d'insérer un ou plusieurs bits dans le flux compressé.

On a représenté pour mémoire sur la figure 2 les différentes étapes de la phase de renormalisation 11 suivant l'état antérieur de la technique c'est-à-dire celle dans laquelle on fait appel à un processus itératif.

Dans une première étape de cette phase on teste en 13 la valeur de CIR afin de savoir si sa taille est ou non inférieure à 1/4. Si tel n'est pas le cas, il n'y a pas de renormalisation et l'on court-circuite cette étape pour le bit considéré.

Si la valeur de CIR est inférieure à 1/4 il doit y avoir remise à échelle autrement dit renormalisation, et l'on multiplie alors successivement par 2 cette valeur tant qu'elle reste inférieure à 1/4. Ce sont ces itérations successives qui représentent un temps d'exécution important.

La présente invention se propose de remplacer tout le processus itératif par un accès direct à une table de référence qui peut être mise en mémoire et qui fournit les différentes valeurs des divers paramètres nécessaires, et notamment a) la séquence des bits à insérer dans le flux, b) le nombre BOI des bits dont la valeur ne peut pas être déterminée et qui sont, pour cette renormalisation, en attente d'insertion. Il restera, une fois ces valeurs déterminées, à procéder à l'insertion des bits dans le flux de sortie.

On passera ensuite au traitement du bit suivant extrait du flux initial.

Le procédé de mise en oeuvre de la présente invention comporte en conséquence une étape préliminaire au cours de laquelle on construit, une fois pour toute, une table de référence T1 que, par exemple on stocke dans une mémoire, ou que l'on câble dans un décodeur logique. Ensuite, c'est cette table de référence T1 que l'on consultera lors de la mise en oeuvre de la renormalisation pour en extraire de façon directe les valeurs obtenues précédemment par itération.

La renormalisation proprement dite comporte ainsi trois étapes essentielles, à savoir : une première étape dans laquelle on détermine l'adresse où les données sont stockées dans la table de référence, et ceci à partir des paramètres. CIL et CIR, une seconde étape de consultation de cette table à ladite adresse, de laquelle on extrait les valeurs précédemment mentionnées, et une troisième étape dans laquelle on insère dans le flux de sortie les bits à insérer, et où on remet à jour le nombre de bits à insérer en attente de la prochaine renormalisation, ainsi que les valeurs de CIL et CIR.

### I - ETAPE PRELIMINAIRE Constitution de la table de référence

On décrira ci-après, à titre d'exemple la constitution de la table de référence T1, destinée à être implantée dans une mémoire, pour toutes les valeurs de CIL et pour un nombre d'itérations de 4 ce qui correspond à une valeur de CIR de 00001XXXX. Pour obtenir le contenu complet de la table, autrement dit pour des itérations de 1 à 7, on procédera de la même manière qu'exposé ci-après.

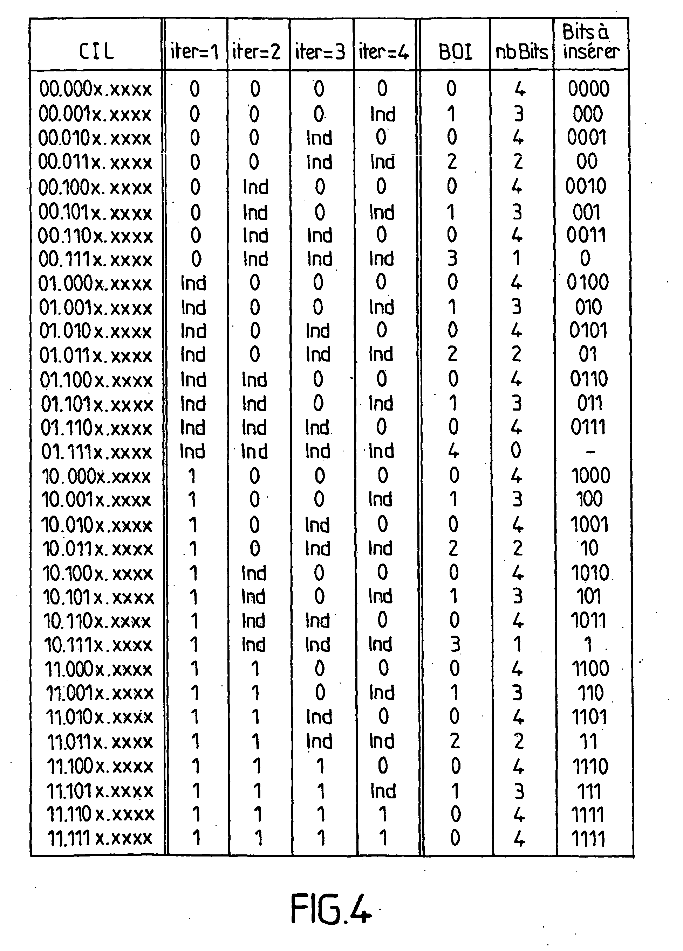

Un exemple de cette table de référence T1 est représenté sur la figure 4. On a mis dans la colonne 1 de celle-ci les différentes valeurs possibles susceptibles d'être prises par CIL et dans les colonnes 2 à 5 les valeurs « 0 » ou « 1 » obtenues quand les itérations faites suivant l'état antérieur de la technique conduisent respectivement à l'insertion d'un O ou d'un, 1, ou la mention « ind » quand cette valeur est indéterminée, l'itération ne pouvant conduire à une décision d'insertion, dans la mesure où celle-ci dépend de la valeur du bit suivant. Dans une telle situation on incrémente BOI. Les valeurs de cette variable sont portées dans la 6^{ème} colonne de la table de référence T1.

Dans la 7^{ème} colonne de la table de référence, T1 on a porté le nombre de bits à insérer, et dans la 8^{ème} colonne on a porté-la séquence des bits à insérer.

Pour établir ladite table un moyen peut par exemple consister à prendre en considération chacune des valeurs successives des 4 colonnes iter₁; iter₂ ; iter₃ ; iter₄. Si la valeur considérée est déterminée on met cette valeur dans la série des bits à insérer.

### Exemple 1

Soit une suite des quatre valeurs iterₙ suivantes :
1 ;1 ;1 ;0 (Tableau T1 ligne 29)
Bits à insérer : 1 1 1 0
Incrémentation de la valeur BOI : 0

Si ces valeurs ne contiennent aucun bit indéterminé elles constitueront les valeurs des bits à insérer, et la valeur de BOI sera égale à 0.

### Exemple 2

Soit une suite des quatre valeurs iterₙ suivantes :
ind ;ind ;0 ;0 (Tableau T1 ligne 13)
Bits à insérer : 0 1 1 0
Incrémentation de la valeur BOI : 0

Si la valeur considérée est indéterminée on va voir alors la valeur suivante jusqu'à ce que l'on arrive soit à une valeur déterminée soit à la fin de la série (ici n=4). Dans ces conditions, si l'on tombe sur une valeur déterminée avant de rencontrer la fin de la série, on insère dans la suite des bits à insérer un bit égal à cette valeur déterminée et on fait suivre celui-ci d'autant de bits inversés (par rapport à cette valeur déterminée) que de valeurs indéterminées le précédant.

### Exemple 3

Soit une suite des quatre valeurs iterₙ suivantes :
0 ;0 ;ind ;ind (Tableau T1 ligne 4)
Bits à insérer : 0 0
Incrémentation de la valeur BOI : 2

Si la valeur considérée est indéterminée et si la fin de la série est atteinte avant que l'on tombe sur une valeur déterminée, on ne peut savoir la valeur des bits à insérer. Dans ces conditions on prend la valeur des bits déterminés rencontrés avant le bit indéterminé considéré et on incrémente le nombre des bits en attente (BOI) d'un nombre égal à celui du nombre des valeurs indéterminées rencontrées.

### Exemple 3' (Cas particulier de l'exemple 3)

Soit une suite des quatre valeurs iterₙ suivantes :
ind ;ind ;ind ;ind (Tableau T1 ligne 16)
Bits à insérer : aucun
Incrémentation de la valeur BOI : 4

Les quatre valeurs étant indéterminées il n'y a dès lors aucun bit à insérer et l'on met à 4 la valeur de BOI.

On porte ainsi dans la table T1 les bits à insérer, la valeur de BOI et le nombre de bits à insérer.

### II - PREMIERE ETAPE : Détermination de l'adresse

L'adresse s'obtient par concaténation des valeurs CIR et CIL. CIR étant donné sur 9 bits et CIL sur 10 bits l'adresse devrait donc nécessiter 19 bits. Cependant on a constaté que, dans l'état antérieur de la technique, chaque itération de la fonction de renormalisation est exclusivement basée sur l'analyse du bit de poids fort de CIR et qu'à chaque itération, on multiplie CIR par 2, ce qui revient à le décaler d'un bit vers la gauche. On peut donc calculer le nombre d'itérations n qui auraient été nécessaires dans le procédé suivant l'état antérieur de la technique en déterminant la position du bit significatif à 1 de poids fort de CIR. De plus, sachant que d'après le standard H.264 la valeur de CIR est supérieure ou égale à 2 avant l'appel à la renormalisation, ses 2 bits de poids faibles ne sont pas utilisés. En notant c[8..0] les 9 bits de CIR, on exploite uniquement les bits c[7...2] pour déterminer le nombre d'itérations. La table de vérité est donnée dans le Tableau I ci-après.

A chaque itération, on n'utilise que les deux bits de poids forts de CIL. Pendant toute l'étape de renormalisation, on n'exploite donc que les n+1 bits de poids forts de CIL (n étant le nombre d'itérations) (2 bits pour une seule itération, soit 4 valeurs dans la mémoire, 3 bits

**TABLEAU I**

| bits de CIR | | | | | | Valeur de n |
|---|---|---|---|---|---|---|
| 7 | 6 | 5 | 4 | 3 | 2 | |
| 1 | x | x | x | x | x | 1 |
| 0 | 1 | x | x | x | x | 2 |
| 0 | 0 | 1 | x | x | x | 3 |
| 0 | 0 | 0 | 1 | x | x | 4 |
| 0 | 0 | 0 | 0 | 1 | x | 5 |
| 0 | 0 | 0 | 0 | 0 | 1 | 6 |
| 0 | 0 | 0 | 0 | 0 | 0 | 7 |

pour 2 itérations, soit 8 valeurs dans la mémoire, etc... Sachant qu'il peut y avoir 7 itérations au maximum, le nombre de cases mémoire nécessaires à la détermination de l'adresse est donc de : 4+8+16+32+64+128+256= 508 mots. On a donc ainsi réduit de façon particulièrement conséquente la capacité mémoire normalement nécessaire.

Cette réduction de la capacité mémoire nécessaire est particulièrement intéressante dans la mesure où l'on sait que, dans de tels dispositifs, la capacité mémoire interne des composants est toujours une ressource critique, puisqu'elle influe non seulement sur le coût des composants mais également sur leur consommation en énergie.

### III - DEUXIEME ETAPE : Lecture de la table de référence T1

Les valeurs de CIR et CIL conduisent directement aux valeurs des paramètres nécessaires, à savoir aux bits à insérer, à la valeur de BOI, au nombre de bits à insérer, à la nouvelle valeur de CIR et à la nouvelle valeur de CIL.

### IV - TROISIEME ETAPE : Insertion des bits à insérer

Cette étape se déroulera en deux temps. Dans un premier temps on insérera les bits à insérer en faisant intervenir la valeur du nombre de bits en attente BO restant de la ou des renormalisations précédentes.

Au cours de ce premier temps on prendra en considération les bits à insérer donnés par la table de référence T1 créée lors de l'étape préliminaire. Après le premier bit, ou bit de poids fort, on insérera un nombre de bits inverses de celui-ci égal au nombre des bits en attente de la ou des renormalisations précédentes, soit BO. On portera ensuite dans BO la valeur de BOI.

S'il n'y a aucun bit à insérer on incrémentera BO avec la valeur de BOI.

Le Tableau II ci-après donne à titre indicatif quelques exemples :

**TABLEAU II**

| | Bits à insérer (de T1) | BO | BOI (de T1) | Bits insérés | BO après renormalisation |
|---|---|---|---|---|---|
| Exemple 1 | 0 1 0 1 | 3 | 0 | 0111101 | 0 |
| Exemple 2 | 1 0 1 | 0 | 1 | 1 0 1 | 1 |
| Exemple 3 | aucun | 1 | 4 | aucun | 5 |
| Exemple 4 | 0 | 2 | 3 | 0 1 1 | 3 |

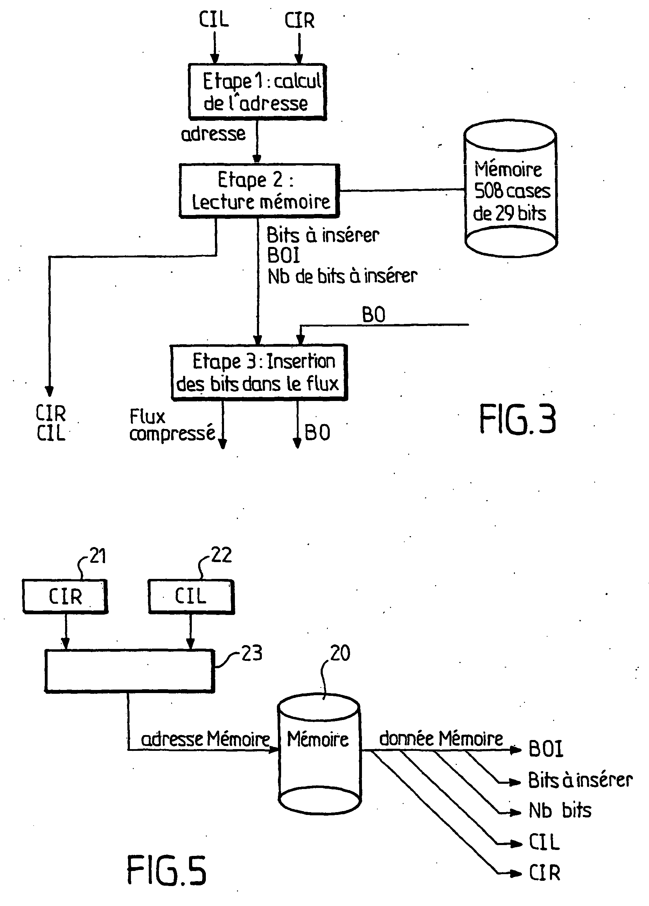

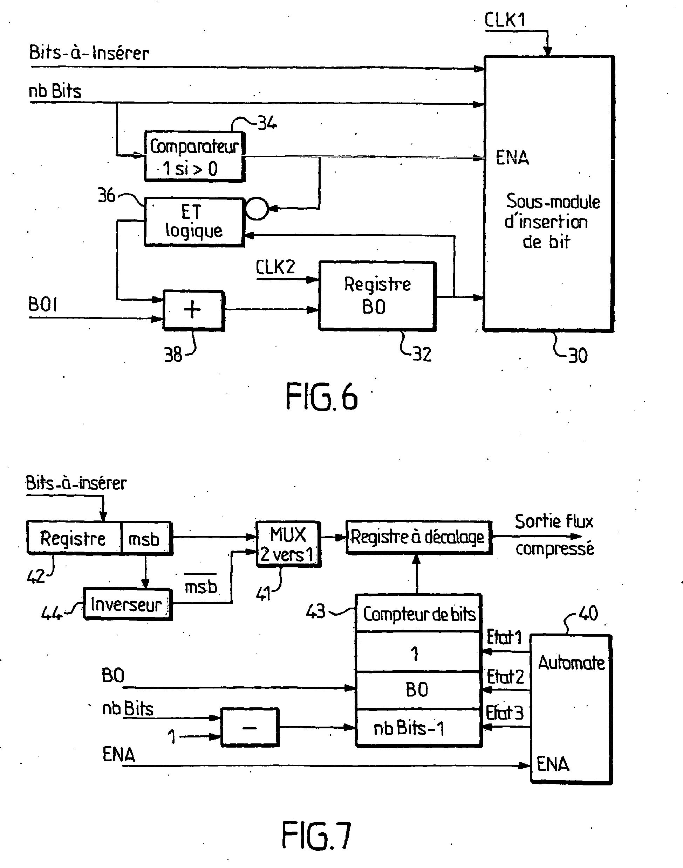

On décrira ci-après, en regard des figures 5 et 6, des moyens de type électronique permettant de mettre respectivement en oeuvre les étapes de lecture (étape 2) et d'insertion de la séquence de bits (étape 3).

Sur la figure 5 la table de référence T1 est contenue dans une mémoire RAM 20 formée de 508 cases de 29 bits. Les valeurs de CIR et CIL sont respectivement contenues dans des registres 21 et 22 et ces valeurs sont transférées à un registre de calcul 23 dans lequel on effectue la concaténation de celles-ci ainsi qu'exposé précédemment. On obtient ainsi directement l'adresse de la mémoire 20 contenant les paramètres recherchés.

On a représenté sur la figure 6 un exemple de moyens électroniques en mesure d'effectuer l'étape d'insertion des bits dans le flux sortant. Ce dispositif est essentiellement constitué d'un sous module d'insertion de bits 30 piloté par un signal d'horloge CLK1, d'un registre 32 dans lequel est stocké le nombre BO des bits en attente de la ou des renormalisations précédentes et qui est piloté par un signal d'horloge CLK2, d'un comparateur 34, d'un ensemble de portes logiques ET 36 et d'un additionneur 38.

Le module d'insertion 30 reçoit de la table T1, non représentée sur le dessin, les bits à insérer ainsi que le nombre de bits à insérer (nbBits). Si ce nombre est supérieur à 0 on active le module d'insertion 30 par sa commande d'activation ENA et on met à 0 la valeur BO lue dans le registre 32, grâce à l'ensemble de portes logiques 36. Cette valeur BO est ensuite réinitialisée avec la valeur BOI lue- dans- la table T1. L'additionneur 38 reçoit- de la table T1 la valeur BOI des bits inconnus en attente d'insertion. Lorsque la valeur du comparateur 34 n'est pas supérieure à 0 (pas de bits à insérer), on remplace seulement, au moyen de l'additionneur 38, la valeur BO par la somme de BO et BOI. Le module d'insertion 30 est activé sur l'horloge CLK1 qui précède l'horloge CLK2 afin que le registre BO puisse être exploité par ce module avant d'être mis à jour.

On a représenté sur la figure 7, un exemple de sous-module d'insertion de bits qui fonctionne en mode série. Ce sous-module est basé sur un automate 40 à 3 états :
- Dans l'état 1, de l'automate 40, un multiplexeur 41 a son entrée orientée sur un registre 42 contenant les bits à insérer qui lui sont fournis par la table T1 et on génère 1 bit (valeur d'un compteur de bits 43 = 1). Ce bit est le poids fort (msb) du registre 42 et constitue le 1^{er} bit à insérer.
- Dans l'état 2, de l'automate 40, le multiplexeur 41 a son entrée orientée sur l'inverse de msb qui lui est fourni par un inverseur 44 et on génère BO bits (valeur du compteur de bits 300 = BO) dont la valeur est ainsi l'inverse du bit précédemment généré. Si BO est nul, on ne génère pas de bits.
- Dans l'état 3, de l'automate 40, le multiplexeur a son entrée orientée sur le registre 42 et on génère le reste des bits à insérer dans le flux, s'il y en a, (valeur du compteur de bits 300 = (nbBits-1) avec nbBits plus grand que 1).

La présente invention peut également être mise en oeuvre de façon logicielle en faisant appel à un processeur de traitement de signal ou tout autre processeur.

Un exemple de traitement logiciel est représenté par le pseudo-code annexé.

### ANNEXE

```
 /* calcul de l'adresse mémoire sur 14 bits (hors concaténation
 sur 9 bits) */
 adresseMemoire = ((CIR & 0xFC) << 8) + (CIL >> 2) ;
 /* lecture de la mémoire : données sur 32 bits */
 donneeMemoire = Memoire[adresseMemoire] ;
 /* Extraction des données utiles */
 Bits-a-Inserer = (donneeMemoire & 0x7F) ;
 BOI = ((donneeMemoire & 0x380) >> 7) ;
 nbBits = ((donneeMemoire & 0x1C00) >> 10) ;
 /* Note : pour CIR, il faut forcer le bit de poids faible à 0 */
 CIR'= ((donneeMemoire & 0xFE000) >> 12) ;
 /* Note : pour CIL, il faut forcer le bit de poids faible à 0 */
 CIL = ((donneeMemoire & 0x1FF00000) >> 19) ;
 /* Toutes les données utiles ont été extraites de la mémoire, on
 peut réaliser l'insertion de bits */
 if (nbBits != 0) then
    msb = (Bits-a-Inserer. >> nbBits) ;
    insertBit(msb, 1) ;
    if (BO != 0) then
    insertBit (!msb, BO);
    end if
    BO = 0
    if (nbBit > 1) then
    insertBit(Bits-a-Inserer, (nbBits-1)) ;
    end if
 end if
 BO = BO + BOI ;
```

La sous-fonction d'insertion de bits insertBit(bits, nombre) dépend de l'architecture interne du processeur. S'il s'agit d'un processeur 32 bits, cela peut être une fonction itérative qui insère 32 bits à chaque cycle dans le flux de sortie.

## Revendications

1. Procédé d'encodage de type CABAC, d'un flux initial d'informations numériques binaires destinées à générer un flux sortant pour former, après décodage, des images vidéo dans lequel :
- on analyse bit à bit des séries successives de bits du flux binaire initial et on en déduit, pour chaque bit, un intervalle représentant la probabilité d'occurrence associée à ce bit, défini par sa taille (CIR) et sa borne inférieure (CIL),
- on analyse cet intervalle et on assure, si nécessaire, une renormalisation de celui-ci, **caractérisé en ce qu'**il comporte une étape unique et préliminaire au cours de laquelle on constitue une table de référence (T1), ce procédé comportant les phases consistant à :
- établir, pour chacune des valeurs possibles de la borne inférieure (CIL) et la taille (CIR), la série des valeurs des bits à insérer dans le flux sortant obtenues à partir d'une détermination des valeurs fournies par les diverses itérations successives fonction de la taille (CIR), compte tenu que ces valeurs pourront être déterminées et seront alors égales à 0 ou à 1, ou indéterminées,
- prendre en considération successivement chacune de ces valeurs et
- si une valeur est déterminée, mettre celle-ci dans la séquence des bits à insérer,
- si une valeur est indéterminée, prendre en considération au moins la valeur suivante jusqu'à ce que l'on arrive à une valeur déterminée ou à la fin de la série, dès lors :
a) si la fin de la série est atteinte avant d'avoir une valeur déterminée, incrémenter la valeur (BOI) des bits inconnus en attente pour cette série d'un nombre égal à celui du nombre des valeurs indéterminées rencontrées,
b) si non, insérer un bit égal à ladite valeur suivante et faire suivre celui-ci d'autant de bits inversés que de valeurs indéterminées le précédant,
- mettre dans la table (T1) la valeur (BOI) du nombre de bits inconnus en attente pour cette série.

2. Procédé d'encodage suivant la revendication 1 **caractérisé en ce que** la renormalisation comporte les étapes consistant à :
- déterminer l'adresse, dans la table de référence (T1), des dites données par concaténation de la valeur initiale de la taille (CIR) dudit intervalle et de la valeur initiale (CIL) de sa borne inférieure,
- accéder aux dites valeurs et extraire les bits devant être insérés dans le flux sortant.

3. Procédé d'encodage suivant la revendication 2 **caractérisé en ce que** l'insertion des bits dans le flux sortant comporte les étapes consistant :
- s'il n'y a aucun bit à insérer, à incrémenter le nombre (BO) de bits en attente avant la renormalisation d'un nombre égal au nombre (BOI) des bits inconnus en attente de la table (T1),
- s'il y a des bits à insérer, à insérer
a) le bit de poids fort de la séquence desdits bits à insérer, suivi
b) de l'inverse de ce bit de poids fort, et ceci un nombre de fois égal à la valeur (BO) du nombre de bits en attente avant la renormalisation, suivi
c) des autres bits à insérer,
d) remplacer le nombre de bits (BO) en attente avant la renormalisation par le nombre de bits inconnus (BOI) en attente lu dans la table (T1).

## Claims

1. A CABAC type method for encoding an initial stream of binary digital information used to generate an output stream to constitute, after decoding, video images, wherein:
- the successive series of bits of the initial binary stream are analyzed bit by bit, and for each bit an interval is deduced representing the probability of occurrence associated with that bit, defined by its magnitude (CIR) and its lower bound (CIL),
- said interval is analyzed, and if necessary a renormalization of it is performed, **characterized in that** it comprises a single preliminary step during which a reference table (T1) is constituted, this method comprising the phases consisting of:
- establishing, for each of the possible values of the lower bound (CIL) and the magnitude (CIR), the series of values of the bits to be inserted into the output stream obtained based on a determination of the values provided by the various successive iterations as a function of the magnitude (CIR), considering that these values can be determinable and will then be equal to 0 or to 1, or undetermined,
- successively taking into consideration each of said values and
- if a value is determined, placing it in the sequence of bits to be inserted,
- if a value is undetermined, taking into consideration at least the following value until a determined value or the end of the series is reached, whereupon:
a) if the end of the series is reached before having a determined value, incrementing the value (BOI) of the unknown bits on standby for this series by a number equal to the number of undetermined values encountered,
b) if not, inserting a bit equal to said following value and following it with as many inverted bits as there are undetermined values preceding it,
- putting in the table (T1) the value (BOI) of the number of unknown standby bits for this series.

2. An encoding method according to Claim 1 **characterized in that** the renormalization comprises the steps consisting of:
- determining the address, in the reference table (T1) of said data by concatenation of the initial value of the magnitude (CIR) of said interval and of the initial value (CIL) of its lower bound,
- accessing said values and extracting the bits needing to be inserted into the output stream.

3. An encoding method according to Claim 2 **characterized in that** the insertion of bits into the output stream comprises the steps consisting of:
- if there are no bits to insert, incrementing the number (BO) of standby bits before the renormalization by a number equal to the number (BOI) of unknown bits on standby from the table (T1),
- if there are bits to insert, inserting
a) the most significant bit of the sequence of said bits to be inserted, followed
b) by the inverse of said most significant bit, repeated a number of times equal to the value (BO) of the number of bits on standby before renormalization, followed
c) by the other bits to be inserted,
d) replacing the number of bits (BO) on standby before the renormalization by the number of unknown bits read from the table (T1).

## Patentansprüche

1. Verfahren zur CABAC-Codierung eines anfänglichen Stromes von binären numerischen Informationen, die zur Erzeugung eines ausgehenden Stroms bestimmt sind, um nach einer Decodierung Videobilder zu bilden, bei welchem:
- aufeinanderfolgende Reihen von Bits des anfänglichen binären Stroms bitweise analysiert werden und für jedes Bit ein Intervall hergeleitet wird, das die zugehörige Wahrscheinlichkeit eines Auftretens dieses Bits repräsentiert und das durch seine Größe (CIR) und seine untere Grenze (CIL) definiert ist,
- dieses Intervall analysiert wird und, falls erforderlich, eine Reformierung von diesem gewährleistet wird, **dadurch gekennzeichnet, dass** es einen einzelnen und vorbereitenden Schritt beinhaltet, im Verlauf von dem eine Referenztabelle (T1) erstellt wird, wobei dieses Verfahren die folgenden Phasen beinhaltet:
- für jeden der möglichen Werte der unteren Grenze (CIL) und der Größe (CIR) wird die Reihe der Werte der in den ausgehenden Strom einzufügenden Bits erstellt, die ausgehend von einer Bestimmung der Werte erhalten werden, welche durch die verschiedenen aufeinanderfolgenden Iterationen in Abhängigkeit von der Größe (CIR) geliefert werden, im Einblick darauf, dass diese Werte bestimmbar sind und dann gleich 0 oder gleich 1 sind, oder unbestimmbar sind,
- sukzessives Berücksichtigen jedes dieser Werte, und
- falls ein Wert bestimmt ist, Einfügen von diesem in die Abfolge von Bits,
- falls ein Wert unbestimmt ist, Berücksichtigten zumindest des folgenden Wertes, bis ein bestimmter Wert oder das Ende der Reihe erreicht wird, und von da an:
a) wenn das Ende der Reihe erreicht wird, bevor man über einen bestimmten Wert verfügt, wird der Wert (BOI) der wartenden unbekannten Bits für diese Reihe um eine Anzahl erhöhe, die gleich groß wie die Anzahl der angetroffenen unbestimmten Werte ist,
b) falls nicht, wird ein Bit gleich groß wie der folgende Wert eingefügt und diesem lässt man so viele invertierte Bits folgen wie ihm unbestimmte Werte vorausgelten,
- in die Tabelle (T1) wird der Wert (BOI) der Anzahl der wartenden unbekannten Bits für diese Reihe eingesetzt.

2. Verfahren zur Codierung nach Anspruch 1, **dadurch gekennzeichnet, dass** die Renormierung die folgenden Schritte beinhaltet:
- Bestimmen der Adresse, in der Referenztabelle (T1), der Daten durch Verkettung des anfänglichen Wertes der Größe (CIR) des Intervalls und des anfänglichen Wertes (CIL) seiner unteren Grenze,
Zugreifen auf diese Werte und Extrahieren der Bits, die in den ausgehenden Strom eingesetzt werden sollen.

3. Verfahren zur Codierung nach Anspruch 2, **dadurch gekennzeichnet, dass** das Einfügen der Bits in den ausgehenden Strom die folgenden Schritte beinhaltet:
- Falls es kein einzufügendes Bit gibt, Erhöhen der Anzahl (BO) der wartenden Bits vor der Renormierung, und zwar um eine Anzahl gleich groß der Anzahl (BOI) der wartenden unbekannten Bits der Tabelle (T1),
- falls es einzufügende Bits gibt, Einfügen
a) des höchstwertigen Bits der Abfolge der einzufügenden Bits, gefolgt von
b) dem Inversen dieses höchstwertigen Bits, und dies eine Anzahl von Malen gleich groß wie der Wert (BO) der Anzahl von wartenden Bits vor der Renormierung, gefolgt von
c) den weiteren einzufügenden Bits,
d) Ersetzen der Anzahl von wartenden Bits (BO) vor der Renormierung durch die Anzahl von wartenden unbekannten Bits (BOI), die in der Tabelle (T1) gelesen worden.
